# FASCICULE DE BREVET EUROPEEN

(11) **EP 3 451 380 B1**
(45) Date de publication et mention de la délivrance du brevet: **29.06.2022**
(21) Numéro de dépôt: 18191381.5
(22) Date de dépôt: 29.08.2018
(51) Int. Cl.: H01L 27/146, H01L 27/12

(54) **DETECTEUR PHOTOSENSIBLE A PN-JONCTION 3D ET GRILLE AUTOALIGNEES**
FOTOSENSIBLER DETEKTOR MIT SELBSTAUSGERICHTETEM 3D-PN-ÜBERGANG UND SELBSTAUSGERICHTETEM GATTER
PHOTOSENSITIVE DETECTOR WITH SELF-ALIGNED 3D PN-JUNCTION AND SELF-ALIGNED GATE

(30) Priorité: 05.09.2017 FR 1758192
(43) Date de publication de la demande: 06.03.2019
(73) Titulaire: Commissariat à l'énergie atomique et aux énergies alternatives, 75015 Paris (FR)
(72) Inventeur: KADURA, Lina, 38000 GRENOBLE (FR); GRENOUILLET, Laurent, 38640 CLAIX (FR); ROZEAU, Olivier, 38430 MOIRANS (FR); TCHELNOKOV, Alexei, 38240 MEYLAN (FR)
(74) Mandataire: Brevalex

(56) Documents cités:
- EP-A1- 2 479 785
- EP-A1- 2 587 539
- EP-A2- 2 947 689
- US-A1- 2001 019 869
- US-A1- 2004 089 890
- US-A1- 2013 320 418
- US-B1- 8 319 307
- TSUCHIYA R ET AL: "Silicon on thin BOX: a new paradigm of the CMOSFET for low-power and high-performance application featuring wide-range back-bias control", ELECTRON DEVICES MEETING, 2004. IEDM TECHNICAL DIGEST. IEEE INTERNATIO NAL SAN FRANCISCO, CA, USA DEC. 13-15, 2004, PISCATAWAY, NJ, USA,IEEE, 13 décembre 2004 (2004-12-13), pages 631-634, XP010788872, DOI: 10.1109/IEDM.2004.1419245 ISBN: 978-0-7803-8684-6

## Description

### DOMAINE TECHNIQUE ET ART ANTÉRIEUR

La présente invention se rapporte au domaine de la photo-détection et de l'imagerie et concerne la mise en œuvre d'un dispositif de photo-détection amélioré sur un substrat de type semi-conducteur sur isolant.

Dans le domaine technique des dispositifs photosensibles, le document EP 2°587°539 présente un dispositif microélectronique formé d'un transistor réalisé sur un substrat de type semi-conducteur sur isolant dont la tension de seuil peut être modulée en fonction d'une quantité de photons reçue par une zone photosensible située dans la couche de support semi-conductrice du substrat. La zone photosensible est séparée de la zone de canal du transistor par l'intermédiaire de la couche isolante du substrat. La variation de tension de seuil du transistor est permise grâce à l'établissement d'un couplage capacitif entre la zone photosensible et la zone de canal du transistor. Ainsi, lorsqu'il n'y a pas de rayonnement lumineux à détecter, la tension de seuil du transistor est égale à une valeur Vt₁, tandis que lorsqu'un rayonnement lumineux est reçu, la tension de seuil du transistor est égale à une valeur Vt₂ différente de Vt₁. Une telle variation de tension de seuil provient d'une accumulation de charges photo-générées à proximité de l'interface entre la couche de support et la couche isolante du substrat.

Le document US8319307 présente un dispositif microélectronique formé d'un transistor réalisé sur un substrat de type semi-conducteur sur isolant. Une zone photosensible connectée à la source du transistor est réalisée dans la couche de support semi-conductrice du substrat au-dessous du transistor.

Il se pose le problème d'améliorer la sensibilité de détection d'un tel type de dispositif microélectronique photosensible.

### EXPOSÉ DE L'INVENTION

Un mode de réalisation de la présente demande prévoit un dispositif photosensible selon la revendication 1.

En particulier, la jonction peut être formée d'une superposition de régions dopées ayant un profil 3D ou non-planaire, réparties autour de ladite zone donnée en régions concentriques.

Selon un mode de réalisation, la zone photosensible comporte parmi lesdites régions dopées:
- une première région dopée selon un dopage d'un premier type, N ou P, la première région dopée étant agencée contre la couche isolante et étant située et en regard de la zone de canal,
- une deuxième région dopée selon un dopage d'un deuxième type, P ou N, la deuxième région dopée étant disposée autour de la première région dopée et s'étendant contre la couche isolante et en regard des zones de source et de drain.

On forme ainsi, une ou plusieurs jonctions ou portions de jonctions PN ou NP ou PIN ou NIP horizontales autrement dit parallèles au plan principal du substrat et configurées de sorte à pouvoir ramener des charges photo-générées dans la couche de support en face des zones de source et de drain vers une zone donnée de la couche de support située quant à elle en face de la zone de canal. Cette meilleure concentration de charges photo-générées en regard du canal permet d'augmenter la sensibilité de détection du dispositif.

De préférence, la deuxième région dopée s'étend en outre sous la première région dopée, de sorte qu'en regard de la zone de canal, la première région dopée se situe entre la couche isolante et la deuxième région dopée. La zone photosensible comporte dans ce cas une jonction ou portion de jonction PN ou NP ou PIN ou NIP à agencement vertical.

Avantageusement, la zone de canal du transistor est agencée entièrement en regard de la première région dopée.

Avantageusement, dans une section transversale de la couche de support, la première région dopée est entièrement entourée par ladite deuxième région dopée. La zone donnée de la couche de support située en regard du canal est ainsi entièrement entourée d'une jonction PN ou NP ou PIN ou NIP

De préférence, une région intermédiaire faiblement dopée est disposée entre ladite première région dopée et ladite deuxième région dopée, de sorte à former une jonction de type PIN ou NIP.

Avantageusement, la première région dopée, la région intermédiaire et la deuxième région dopée forment une jonction de type PIN ou NIP et sont réparties de manière concentrique autour de la zone donnée de la couche de support située entièrement en regard de la zone de canal du transistor et contre la couche isolante.

Pour améliorer davantage la sensibilité du dispositif, on peut prévoir une première région avec une largeur prévue légèrement supérieure à la longueur de grille du transistor.

La première région dopée peut être ainsi délimitée latéralement par des bords latéraux disposés en regard d'espaceurs isolants agencés contre la grille.

Un autre aspect de la présente invention concerne un procédé de réalisation de la zone photosensible à agencement non-planaire ou 3D des régions dopées.

Un mode de réalisation du procédé selon la revendication 9 de mise en œuvre d'un dispositif tel que décrit précédemment prévoit, à partir d'un substrat dans lequel la couche de support du substrat est dopée selon le dopage du deuxième type, P ou N, des étapes de :
- réalisation sur le substrat d'une grille sacrificielle et d'un masque autour de la grille sacrificielle,
- retrait de la grille sacrificielle de sorte à former une ouverture entourée par le masque,
- implantation à travers l'ouverture, de sorte à doper selon le premier type de dopage N ou P, une portion de la couche de support disposée en regard de l'ouverture.

La portion dopée a ainsi avantageusement des dimensions qui dépendent de celles de la grille sacrificielle. Ensuite, si l'on forme dans l'ouverture une grille de remplacement, les dimensions de la portion dopée dépendent également de celle de la grille de remplacement. Ladite portion dopée correspond typiquement à la première région dopée du dispositif défini plus haut.

Un autre mode de réalisation selon la revendication 10 prévoit un procédé de mise en œuvre d'un dispositif photosensible tel que décrit précédemment à partir d'un substrat dans lequel la couche de support du substrat est dopée selon le dopage du deuxième type, P ou N, le procédé comprenant les étapes de :
- implantations inclinées, respectivement selon un angle α₁ et un angle -α₂ par rapport à un plan donné orthogonal au plan principal du substrat, de sorte à doper selon un dopage du premier type une première portion de la couche de support en regard de la grille,
- implantation parallèlement au plan donné de sorte à doper selon le dopage du deuxième type des deuxièmes portions de la couche de support de part et d'autre de la première portion. α₁ et α₂ sont des angles non-nuls et typiquement égaux.

Un autre mode de réalisation du procédé selon la revendication 11 de mise en œuvre d'un dispositif photosensible dans lequel une grille de transistor est formée sur le substrat semi-conducteur sur isolant, la couche de support du substrat étant dopée selon le dopage du deuxième type, par exemple de type P, prévoit :
- des premières implantations inclinées respectivement selon des angles α₁ et -α₁ par rapport à un plan donné orthogonal au plan principal du substrat, de sorte à doper sous la grille une portion de la couche de support selon un dopage d'un premier type, par exemple de type N.
- des deuxièmes implantations inclinées selon respectivement des angles α₂, -α₂ tels que α₂ < α₁ par rapport au plan donné de sorte à augmenter la profondeur de ladite portion dopée ayant un dopage du premier type.

Un autre mode de réalisation du procédé selon la revendication 12 dans lequel la couche de
support est initialement dopée selon le dopage du deuxième type, par exemple de type P, comprend les étapes de :
- implantation de sorte à doper une sous-couche supérieure de la couche de support selon un dopage du premier type, puis
- formation d'une grille, puis,
- implantation de part et d'autre de la grille, de sorte à doper selon le dopage du deuxième type des portions de la couche de support situées de part et d'autre d'une portion centrale agencée en regard de la grille.

Avantageusement, après implantation des portions on forme une couche de masquage contre des flancs de la grille, puis on réalise au moins une nouvelle implantation de part et d'autre de la grille de sorte à augmenter le dopage du deuxième type de certaines parties desdites portions.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 sert à illustrer un dispositif photosensible à transistor, qui ne forme part de l'objet revendiquée, formé sur un substrat semi-conducteur sur isolant et doté d'une jonction à agencement 2D disposée en regard du transistor dans la couche de support du substrat, la jonction ayant un agencement planaire 2D ;
- les figures 2, 3A-3C servent à illustrer un exemple de dispositif photosensible selon un mode de réalisation de la présente invention doté d'un transistor formé sur un substrat semi-conducteur sur isolant et, dans la couche de support du substrat, d'une jonction à agencement 3D permettant de concentrer des charges photo-générées essentiellement dans une zone donnée de la couche de support située en regard de la zone de canal du transistor ;
- les figures 4A-4B servent à illustrer des différences de performances en termes du décalage de tensions de seuil induit par la lumière (LIVS) entre un dispositif photosensible à jonction 2D tel que sur la figure 1 et un dispositif photosensible à jonction 3D tel que sur les figures 3A-3C ;
- la figure 5 sert à illustrer des différences de performances en termes de LIVS entre deux dispositifs photosensibles à jonction 3D ayant des niveaux de dopages différents de la première région dopée de la zone photosensible ;
- les figures 6A-6B servent à illustrer une variante de mise en œuvre de dispositif suivant l'invention à jonction 3D formée d'une zone dopée qui s'étend en regard du canal et de la grille du transistor et dont les limites latérales sont situées en regard des espaceurs ;
- les figures 7A-7B servent à illustrer des différences de sensibilité entre un dispositif photosensible muni d'une jonction 3D telle que mise en œuvre suivant l'invention et d'autres types d'agencements ;
- les figures 8A-8D servent à illustrer des étapes d'un premier exemple de procédé de réalisation d'un dispositif photosensible suivant l'invention ;
- les figures 9A-9C servent à illustrer des étapes d'un deuxième exemple de procédé de réalisation d'un dispositif photosensible suivant l'invention ;
- les figures 10A-10C servent à illustrer des étapes d'un troisième exemple de procédé de réalisation d'un dispositif photosensible suivant l'invention ;
- les figures 11A-11C servent à illustrer des étapes d'un quatrième exemple de procédé de réalisation d'un dispositif photosensible suivant l'invention ;
- les figures 12A-12B servent à illustrer une variante de mise en œuvre du quatrième exemple de procédé ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

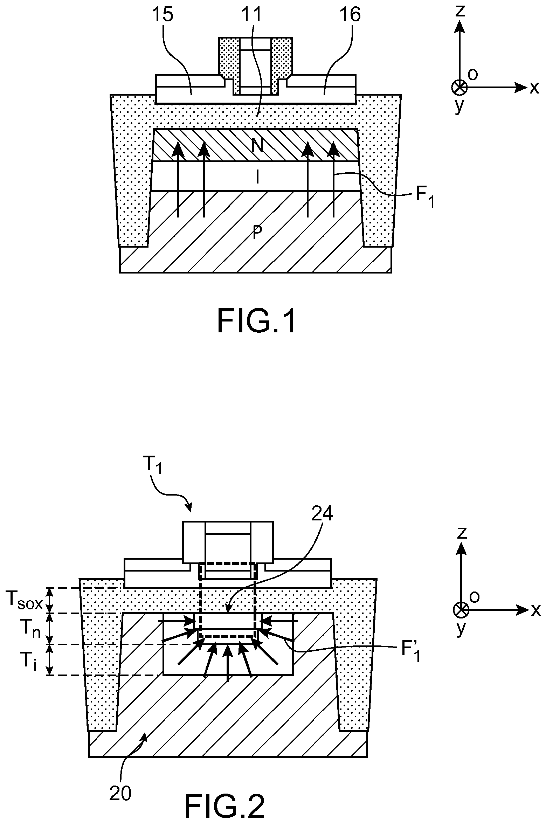

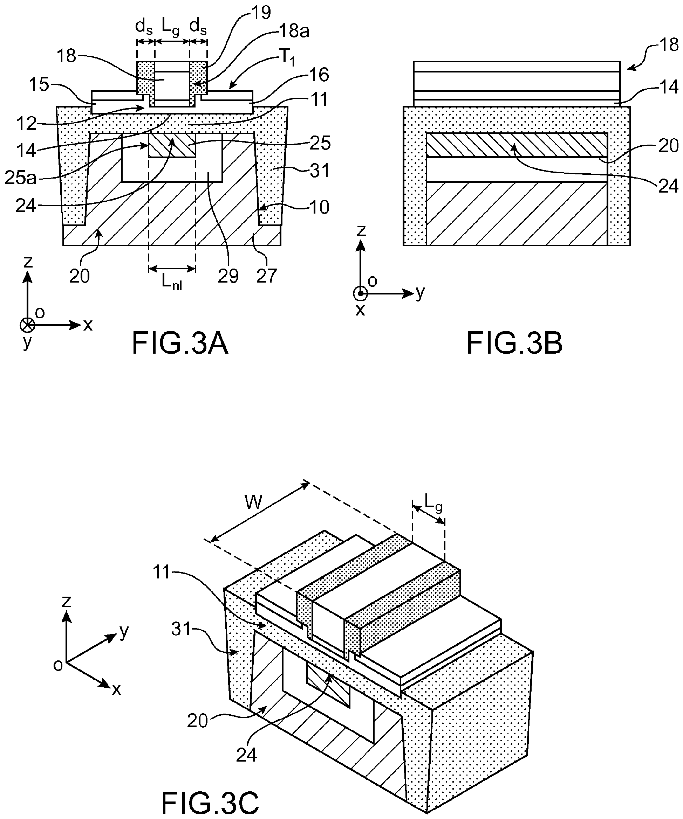

Un exemple de dispositif photosensible mis en œuvre suivant un mode de réalisation de la présente invention est illustré sur les figures 2 et 3A-3C.

Le dispositif est doté d'un transistor T₁ couplé à une zone photosensible 20.

Le transistor T₁ est formé sur un substrat de type semi-conducteur sur isolant et comprend une couche de support 10 semi-conductrice, une couche isolante 11 reposant sur une face dite « face avant » de la couche de support 10, et une couche semi-conductrice 12 superficielle reposant sur la couche isolante 11 et dans laquelle la zone de canal du premier transistor T₁ est agencée.

Le substrat est par exemple de type SOI (SOI pour « Silicon on Insulator » ou silicium sur isolant), tandis que le transistor T₁ est typiquement un transistor MOS (MOS pour « Metal Oxide Semi-conductor ») et peut être réalisé par exemple selon une technologie de type SOI totalement désertée - FDSOI (pour « Fully Depleted Silicon On Insulator »). Le dispositif est typiquement muni de tranchées d'isolation 31 par exemple remplies d'oxyde de silicium, prévues de part et d'autre du transistor T₁.

La zone photosensible 20 est quant à elle agencée dans la couche de support 10 et séparée de la zone de canal 14 du transistor T₁ par l'intermédiaire de la couche isolante 11 du support. Cette couche isolante 11 est prévue, en particulier de par sa composition et son épaisseur, de manière à permettre l'établissement d'un couplage capacitif également appelé couplage électrostatique entre la zone photosensible et la zone de canal 14 du transistor. Un exemple de réalisation prévoit une couche isolante 11 à base de SiO₂ ayant une épaisseur qui peut être comprise entre 5nm et 50nm, de préférence entre 10nm et 25nm.

Le couplage capacitif est tel qu'une variation de potentiel consécutive à la réception d'un rayonnement lumineux au niveau de la zone photosensible 20 permet de générer une variation LIVS (avec « LIVS » pour « Light Induced V_{T} Shift » ou décalage de tension de seuil V_{T} induite par la lumière) de la tension de seuil V_{T} du transistor T.

La variation de tension de seuil V_{T} du transistor T₁, consécutive à un éclairement ou une variation d'éclairement de la zone photosensible 20 peut par exemple atteindre une valeur de l'ordre de 10mV à 250mV.

En adaptant les épaisseurs respectives de la couche isolante 101, et/ou de la couche semi-conductrice superficielle 12, et/ou du diélectrique de grille du transistor on peut ajuster ce décalage de tension de seuil.

Une diminution de l'épaisseur de la couche isolante 11, et/ou une augmentation de l'épaisseur de la couche semi-conductrice superficielle 12, et/ou une augmentation de l'épaisseur du diélectrique de grille des transistors sont en particulier favorables à une augmentation de ce décalage de tension de seuil.

La zone photosensible 20 est ici formée d'une première région 25 dopée selon un type de dopage donné, par exemple un dopage de type N et d'une deuxième région 27 dopée selon un autre type de dopage, opposé au type de dopage donné, dans cet exemple un dopage de type P.

La zone photosensible 20 est ainsi formée d'au moins une jonction, dont l'agencement dans la couche de support 10 est prévu de sorte à permettre une meilleure concentration de charges photo-générées dans la couche de support 10 vers une zone donnée 24 de cette couche 10 située contre la couche isolante 11 et placée en regard de la zone 14 de canal du transistor. Cette zone donnée 24 a dans cet exemple de réalisation, une dimension critique Lnl mesurée dans un plan parallèle au plan du substrat égale ou sensiblement égale à celle de la longueur Lg de grille 18 du transistor T₁. Par « plan principal » du substrat, on entend un plan passant par le substrat et qui est parallèle au plan [O ;x ;y] du repère [O ;x ;y ;z] donné sur les figures 2A-2C et 3.

Par « dimension critique » on entend la plus petite dimension d'un élément hormis son épaisseur, cette dimension étant mesurée parallèlement au plan [O ;x ;y]. La longueur de grille Lg est quant à elle une dimension de la grille 18 du transistor mesurée parallèlement à un axe passant par la région de source et la région de drain du transistor T₁, cet axe étant également parallèle au plan principal du substrat. Ainsi, les bords latéraux 25a de la première région dopée 25 s'étendent au moins jusqu'en regard de flancs latéraux 18a de la grille 18.

La première région 25 dopée s'étend contre la couche isolante 11 et en regard de la zone 14 de canal. De préférence, la zone 14 de canal du transistor est disposée entièrement en regard de la première région dopée 25.

Par rapport à un agencement qualifié de « 2D » du type de celui de la figure 1, le dispositif photosensible illustré sur les figures 2 et 3A-3C présente une sensibilité améliorée du fait d'une concentration plus efficace des charges photo-générées vers la zone donnée 24 de la couche de support située en regard de la zone 14 de canal.

Le dispositif photosensible à jonction 2D de la figure 1 permet d'établir un champ électrique uniforme dans un plan parallèle au substrat. Les charges photo-générées se déplacent ainsi dans une direction sensiblement verticale (autrement dit sensiblement orthogonale au plan principal du substrat). Par conséquent, des charges photo-générées dans des parties de la couche de support 10 qui se situent en regard des zones de source 15 et de drain 16 se déplacent vers d'autres parties de la couche de support 10 qui se situent également en regard des zones de source 15 et de drain mais davantage à proximité de la couche isolante 11. Un tel déplacement est illustré de manière schématique par le biais de flèches F1.

La concentration améliorée des charges photo-générées dans le dispositif suivant l'invention est permise du fait d'un agencement amélioré des régions dopées formant la jonction.

La deuxième région dopée 27 est en particulier agencée de part et d'autre de la première région 25, et s'étend contre la couche isolante 10 et en regard des zones de source 15 et de drain 16

Ainsi, de par une telle répartition des régions 25 et 27, des charges photo-générées dans des parties de la couche de support 10 qui se situent en regard des zone de source 15 et de drain 16 sont susceptibles d'être déplacées vers la zone donnée 24 de la couche de support 10 qui se trouve en regard de la zone de canal 14 et a des dimensions dans un plan parallèle au plan du substrat égales ou sensiblement égales à celles de la grille 18 du transistor T₁.

Avantageusement, la deuxième région 27 dopée s'étend également sous la première région 25 dopée.

On prévoit ainsi de préférence une répartition, non-planaire, encore qualifiée de « 3D », de la superposition de régions dopées formant la jonction.

Dans l'exemple particulier des figures 2, 3A-3C, la jonction est ainsi répartie sur 3 dimensions et plus particulièrement de sorte que dans une section transversale de la couche de support 10 (i.e. une section orthogonale au plan principal du substrat), la première région 25 dopée est entièrement entourée par ladite deuxième région dopée. La zone donnée 24 située contre la couche isolante 11 en regard de la zone de canal 14 du transistor voit ainsi une jonction répartie tout autour d'elle. La première région dopée 25 et la deuxième région dopée 27 sont agencées de manière concentrique autour de la zone donnée 24.

Dans ce mode de réalisation particulier, la jonction a, dans un plan orthogonal à un plan principal du substrat, un profil incurvé ou recourbé autour de la zone donnée 24 de la couche de support située en regard de la zone 14 de canal.

Du fait d'un tel agencement de la jonction on peut obtenir un déplacement des charges photo-générées tel que sur la figure 2. Les composantes du champ et le déplacement induit sont représentés de manière schématique par le biais de flèches F'1, orientées dans différentes directions non-parallèles entre elles et concentriques dirigées vers la zone donnée 24 de la couche de support situé en regard du canal.

La jonction formée dans la couche de support 10 est de préférence une jonction de type PIN ou NIP, afin d'optimiser la collection de charges photo-générées par l'absorption de photons dans la zone de charge d'espace.

Ainsi entre la première région dopée 25 et la deuxième région dopée 27, une région 29 intermédiaire non-dopée ou faiblement dopée qui servira de zone de déplétion est de préférence établie.

La région faiblement dopée peut être une région à la fois dopée par au moins une espèce accepteuse d'électrons et au moins une espèce donneuse d'électrons, les deux types d'espèces se compensant de sorte à créer un dopage global faible de type N ou P. Par « faible » ou « faiblement dopé », on entend que la concentration d'espèce majoritaire est comprise entre 10¹⁴ et 10¹⁶ cm⁻³.

La deuxième région dopée 27 est quant à elle prévue avec une concentration typiquement entre 1e17 et 1e19/cm³ de préférence entre 1e18 et 5e18/cm³.

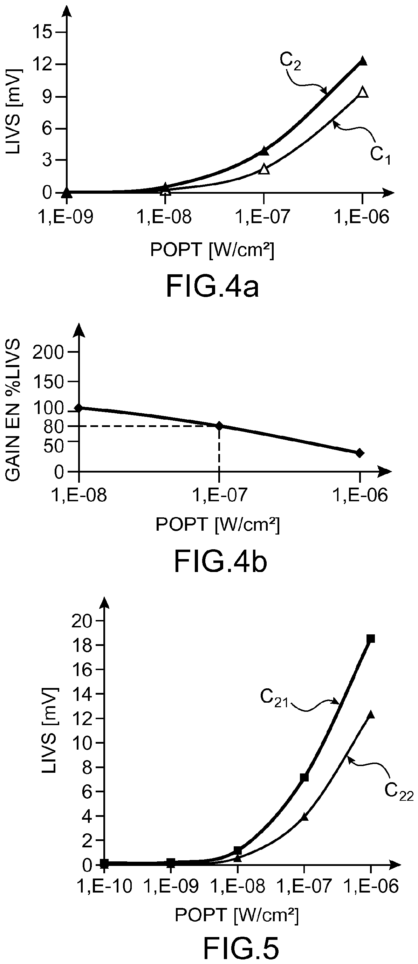

Sur la figure 4A, des courbes C₁ et C₂ sont représentatives de variations du paramètre LIVS en fonction de la puissance optique reçue et illustrent les performances respectivement d'une structure photosensible à jonction NIP de type « 2D » telle qu'illustrée sur la figure 1 et d'une structure suivant l'invention à jonction NIP de type « 3D » telle que sur la figure 2. Pour ces deux exemples de structures, la couche isolante 11 du substrat est en oxyde silicium avec une épaisseur de l'ordre de 25 nm. Le transistor a une grille de longueur Lg de l'ordre de 60 nm, une largeur W de 1000 nm. L'épaisseur Tn de la région dopée N située sous le BOX est de l'ordre de 150 nm tandis que l'épaisseur Ti de la région 29 de type I faiblement dopée est de l'ordre de 100 nm (les épaisseurs Ti, Tn étant des dimensions mesurées parallèlement à l'axe z.

Comme cela est illustré sur la figure 4B, une structure à jonction 3D suivant l'invention permet de réaliser un gain de performances en termes de LIVS de l'ordre de 80% par rapport à une structure à jonction 2D, à faible intensité de l'ordre de 1e-7 W/cm².

Pour améliorer les performances d'une structure à jonction 3D telle que décrite précédemment, on peut augmenter les concentrations de dopants dans la première région 25 dopée formée en regard de la zone de canal.

Sur la figure 5, les courbes C₂₁ et C₂₂ sont représentatives de l'évolution du paramètre LIVS en fonction de l'intensité lumineuse pour des structures photosensibles à jonction NIP de type « 3D » suivant l'invention respectivement avec une concentration de dopants de l'ordre de 1.75e18/cm³ et avec une concentration de dopants de l'ordre de 1e19 /cm³ dans la première région dopée 25. Une telle augmentation de la concentration de dopants peut permettre d'obtenir un gain de l'ordre de 80% de LIVS pour une intensité de l'ordre de 1e-7 W/cm².

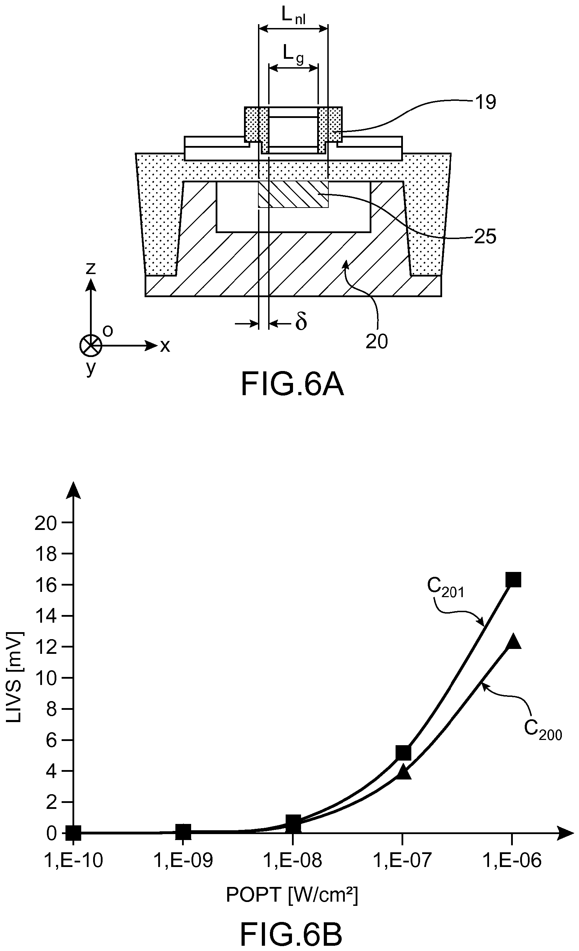

Afin d'améliorer la sensibilité de détection, on peut également prévoir une variante de réalisation telle qu'illustrée sur la figure 6A, dans laquelle la première région 25 est dopée avec une dimension critique Lₙₗ prévue cette fois légèrement supérieure à la longueur Lg de grille du transistor T₁.

Par « légèrement supérieure » on entend que le dépassement δ par rapport la longueur de grille est inférieur à 40nm et prévu inférieur à l'épaisseur des espaceurs 19. Ainsi, la dimension critique Lₙₗ est choisie inférieure à une longueur totale Lₘₐₓ prédéterminée égale à la longueur de grille Lg additionnée à une épaisseur cumulée 2^{∗}ds d'espaceurs 19 disposés de part et d'autre la grille 18. L'épaisseur ds des espaceurs 19 tout comme la longueur de grille Lg est une dimension mesurée parallèlement à l'axe x du repère [O; x; y; z]. Autrement dit, on prévoit la dimension critique Lₙₗ telle que Lg ≤ Lₙₗ < Lg + 2^{∗}ds.

Pour une grille de dimension par exemple de l'ordre de 30nm le dépassement δ peut être prévu par exemple de l'ordre de 60nm.

Sur la figure 6B, les courbes C₂₀₀ et C₂₀₁ sont représentatives de l'évolution du paramètre LIVS en fonction de l'intensité lumineuse pour des structures photosensibles suivant l'invention avec une dimension critique Lₙₗ de la première région dopée 25 respectivement égale à la longueur Lg de grille du transistor T₁, et égale à Lg+60 nm. Un tel ajustement du dépassement δ peut permettre d'obtenir un gain de l'ordre de 30% de LIVS pour une intensité de l'ordre de 1e-7 W/cm².

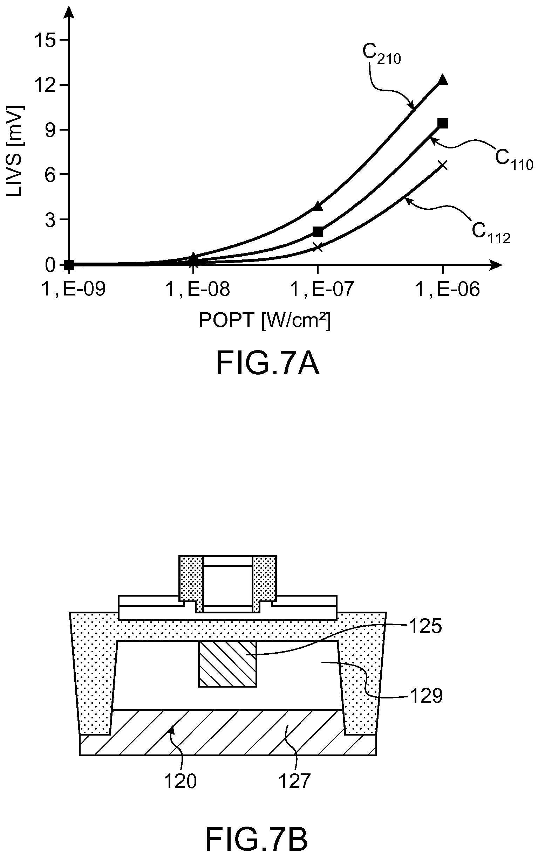

Sur la figure 7A, les courbes C₁₁₀, C₂₁₀, et C₁₁₂ sont représentatives de l'évolution du paramètre LIVS en fonction de l'intensité lumineuse respectivement pour une structure photosensible à jonction de type « 2D » telle qu'illustrée sur la figure 1, pour une structure à jonction « 3D » suivant l'invention et pour une structure à zone photosensible 120 qualifiée de « 2.5D » telle qu'illustrée sur la figure 7B. Elles montrent la sensibilité améliorée que confère l'agencement 3D de la jonction.

Dans l'agencement 2.5D de la figure 7B la zone photosensible 120 est formée d'une première région dopée 125 en regard de la grille du transistor, par exemple dopée N totalement entourée d'une région 129 de type I faiblement dopée ou non dopée et disposée sur une couche 127 dopée P.

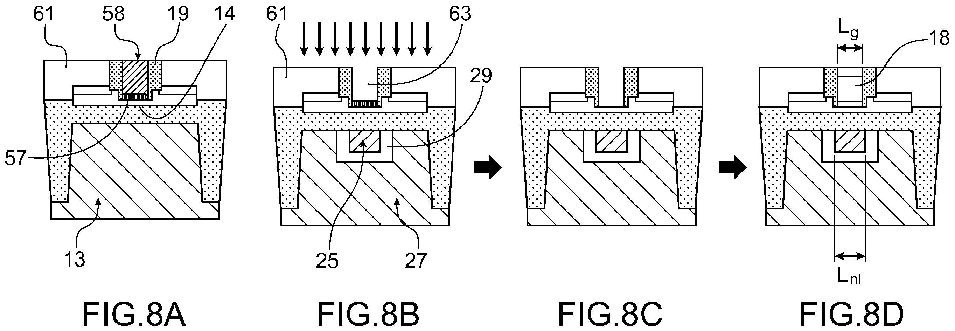

Des étapes d'un procédé de réalisation d'un dispositif photosensible du type de celui décrit précédemment sont illustrées sur les figures 8A-8D.

Le dispositif photosensible est réalisé à partir d'un substrat de type semi-conducteur sur isolant tel qu'évoqué précédemment avec une couche semi-conductrice 12 superficielle est en silicium. La couche de support 10 semi-conductrice peut également être en silicium.

Cette couche de support 10 peut être dopée selon un type de dopage donné, par exemple à l'aide d'une espèce accepteuse, afin de réaliser un puits 13 ayant un dopage de type P. Pour former un puits 13 dopé P (« P-type Well ») dans la couche de support 10, on peut effectuer une implantation de Bore selon une énergie comprise typiquement entre 30 keV et 250 keV, de préférence entre 120 keV and 200 keV, et une dose typiquement comprise entre 1e12 cm⁻² et 1e14 cm⁻², de préférence entre 1.2e12 cm⁻² et 4e13 cm⁻². En variante, une implantation d'Indium peut être mise en œuvre.

Une étape du procédé illustrée sur la figure 8A, consiste à réaliser une grille dite « sacrificielle » 58 d'un transistor dont le canal est prévu dans la couche superficielle 12. La grille 58 sacrificielle est par exemple en polysilicium ou silicium amorphe et repose sur une couche diélectrique 57, par exemple en SiO₂, elle-même disposée sur une zone 14 de la couche superficielle 12 dans laquelle le canal est prévu.

Autour de la grille sacrificielle 58, une couche 61 d'encapsulation est formée. La couche 61 d'encapsulation est typiquement une couche d'oxyde déposée sur la grille puis planarisée par procédé CMP (Chemical Mechanical Planarisation) de sorte à retirer une épaisseur de cette couche et dévoiler la face supérieure de la grille sacrificielle 58. La couche 61 d'encapsulation peut être disposé autour et contre des espaceurs isolants 19, par exemple en nitrure de silicium, eux-mêmes agencés contre des flancs latéraux de la grille sacrificielle 58. Lorsqu'un masque dur est prévu sur la grille sacrificielle, on peut alors retirer ce masque dur sélectivement vis-à-vis du matériau de la couche d'encapsulation. Un tel retrait sélectif est réalisé par exemple avec de l'acide orthophosphorique lorsque le masque du est en nitrure de silicium et la couche d'encapsulation en oxyde de silicium.

La grille sacrificielle 58 est ensuite retirée de sorte à réaliser une ouverture 63 prenant la forme de la grille sacrificielle 58. Ce retrait peut être effectué par exemple par gravure à l'aide d'acide nitrique ou à base de TMAH (Tetramethylammonium hydroxide) lorsque la grille sacrificielle 58 est en polysilicium.

Avantageusement, à ce stade du procédé, on conserve la couche diélectrique 57 qui pourra servir ensuite de couche de protection de la zone 14 de canal.

Puis, on effectue un dopage par implantation d'une portion 25 de la couche de support 10 située en regard de l'ouverture 63 et par conséquent de la zone de canal 14. Dans le cas illustré sur la figure 8B où le puits 13 déjà réalisé dans la couche de support 10 est dopé P, on effectue cette implantation à l'aide d'une espèce donneuse afin de doper une portion 25 ayant un dopage opposé à celui du puits 13, dans cet exemple un dopage de type N.

La portion 25 dopée N forme la première région dopée de la jonction et peut être entourée d'une région intermédiaire 29 faiblement dopée enveloppant cette première région 25.

La première région 25 a ainsi, dans un plan parallèle au plan principal du substrat, des dimensions qui dépendent de celles de l'ouverture 63 et donc de la grille sacrificielle retirée.

Le dopage de type N est par exemple effectué à l'aide de Phosphore en utilisant une énergie d'implantation typiquement comprise entre 10 keV et 200 keV, de préférence entre 35 keV et 110 keV, selon une dose typiquement comprise entre 1e12cm⁻² et 1e14cm⁻², de préférence entre 1.2e13cm⁻² et 4e13cm⁻²

Un autre exemple de réalisation prévoit une implantation d'Arsenic selon une énergie qui peut être comprise entre 10 keV et 200 keV, de préférence entre 80 keV et 110 keV, avec une dose typiquement comprise entre 1e12 cm⁻² et 1e14 cm⁻², de préférence entre 5e12 cm⁻² et 5e13 cm⁻². Lorsque la couche de diélectrique 57 de grille a été conservée, celle-ci permet alors de protéger la zone 14 de canal lors de l'implantation. Les portions du puits 13 dopé qui gardent un dopage globalement de type P forment la deuxième région dopée 27 enveloppant la région intermédiaire 29.

Lors d'une étape ultérieure illustrée sur la figure 8C, on retire la couche diélectrique 57. Ce retrait peut être réalisé par gravure sélective vis-à-vis du matériau de la couche d'encapsulation 61 et des espaceurs, par exemple une gravure à l'aide d'acide fluorhydrique (HF) dilué.

On peut ensuite former une grille 18 de remplacement, en déposant un diélectrique de grille puis un matériau de grille dans l'ouverture 63.

La grille a, dans un plan parallèle au plan principal du substrat, des dimensions qui correspondent à celles de la grille sacrificielle retirée précédemment. Ainsi, dans un plan parallèle au plan principal du substrat, la première région 25 a en particulier une dimension critique Lnl qui correspond sensiblement à la longueur Lg de la grille 18.

L'exemple de procédé qui vient d'être décrit concerne la réalisation d'une jonction PIN ou PN avec une région 25 dopée N enrobée d'une région 27 dopée P.

On peut en variante réaliser une jonction NIP ou NP avec une région 25 dopée N enrobée d'une région 27 dopée P.

Pour cela, on réalise un puits 13 de type N, par exemple en effectuant une implantation à l'aide de Phosphore, selon une énergie typiquement comprise entre 100 keV et 300 keV, de préférence entre 155 keV et 240 keV, selon une dose typiquement choisie entre 1e12cm⁻² et 1e14cm⁻², de préférence entre 1.2e12cm⁻² et 4e13cm⁻².

Dans ce cas, l'implantation décrite précédemment en lien avec la figure 8B est une implantation d'espèce accepteuse afin de former une première région 25 dopée P. Pour réaliser une région 25 dopée P, on peut effectuer par exemple une implantation à base d'Indium selon une énergie comprise entre 100 keV et 300 keV, de préférence entre 130 keV et 200 keV, avec une dose typiquement comprise entre 1e12cm⁻² et 1e14cm⁻², de préférence entre 5e12cm⁻² et 5e13cm⁻².

Selon un autre exemple, on réalise le dopage de type P de la région 25 en effectuant une implantation à base de Bore avec une énergie typiquement comprise entre 1 keV et 5 keV, de préférence entre 10 keV et 40 keV, avec une dose typiquement prévue entre 1e12cm⁻² et 1e14cm⁻², de préférence entre 5e12cm⁻² et 5e13cm⁻².

Un autre exemple de procédé prévoit, contrairement au précédent exemple, une réalisation de la grille du transistor avant de former la jonction.

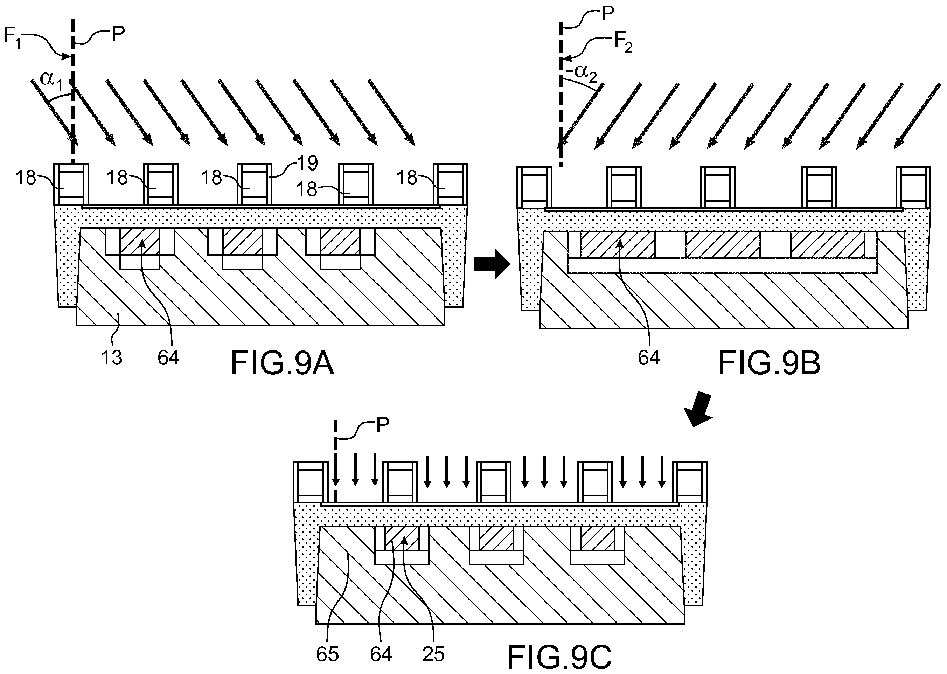

Dans l'exemple illustré sur la figure 9A, on a réalisé plusieurs grilles 18 de transistors en regard d'un puits 13 dopé P formé dans la couche de support d'un substrat semi-conducteur sur isolant. Les flancs latéraux des grilles 18 sont typiquement recouverts d'espaceurs isolants 19.

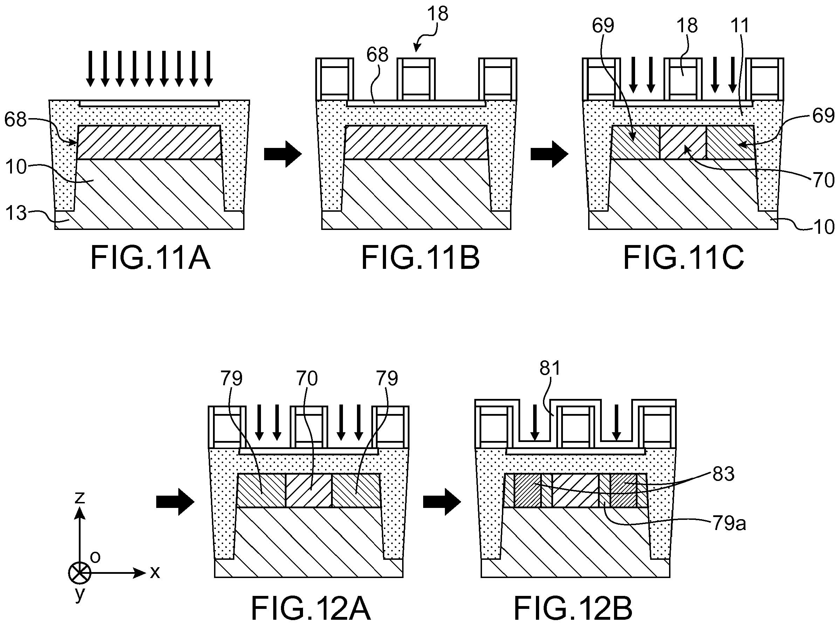

On effectue tout d'abord un dopage de type N de portions 64 de la couche de support 10 situées respectivement sous les grilles 18. Pour cela, on réalise, comme cela est illustré sur la figure 9A, au moins une implantation inclinée selon un angle α₁ par rapport une première face Fi d'un plan P donné orthogonal au plan principal du substrat et qui s'étend dans la direction de la largeur W de la grille (autrement dit dans une direction parallèle à l'axe y sur la figure 11A). L'implantation est effectuée à l'aide d'une première espèce dopante, dans l'exemple de la figure 11A une espèce accepteuse d'électrons.

L'angle α₁ est choisi en fonction des dimensions de la grille. Typiquement, on prévoit un angle α₁ d'implantation compris entre 0 et 40°

On effectue ensuite au moins une autre implantation inclinée selon un angle -α₂ par rapport une face F₂ du plan donné P opposée à la première face Fi. De préférence, on choisit les angles α₁ et α₂ égaux de sorte que les faisceaux d'implantations soient symétriques par rapport au plan P. On élargit ainsi les portions 64 dopées de type N de sorte qu'elles s'étendent entièrement en regard des grilles 18. Typiquement, on prévoit 0 < α₁ < 40°.

On effectue ensuite une étape d'implantation verticale, c'est à dire réalisée cette fois parallèlement au plan P donné.

Le dopage est mis en œuvre à l'aide d'une deuxième espèce dopante qui est une espèce donneuse d'électrons lorsque la première espèce dopante est une espèce accepteuse d'électrons, et une espèce accepteuse d'électrons lorsque la première espèce dopante est une espèce donneuse d'électrons.

Dans l'exemple illustré sur la figure 9C, on effectue une implantation de type P, de sorte à rétrécir les portions 64 dopées selon le dopage de type N et former autour des portions dopées 65 selon un dopage de type P. Le dopage peut être semblable à celui effectué pour réaliser le puit 13 dopé P, mais avec une énergie d'implantation plus faible.

Dans cet exemple, la première région 25 dopée de la zone photosensible est formée de la portion 64 dopée N tandis que la deuxième région 27 dopée est formée des portions 65 implantées et du puit 13 dopé P.

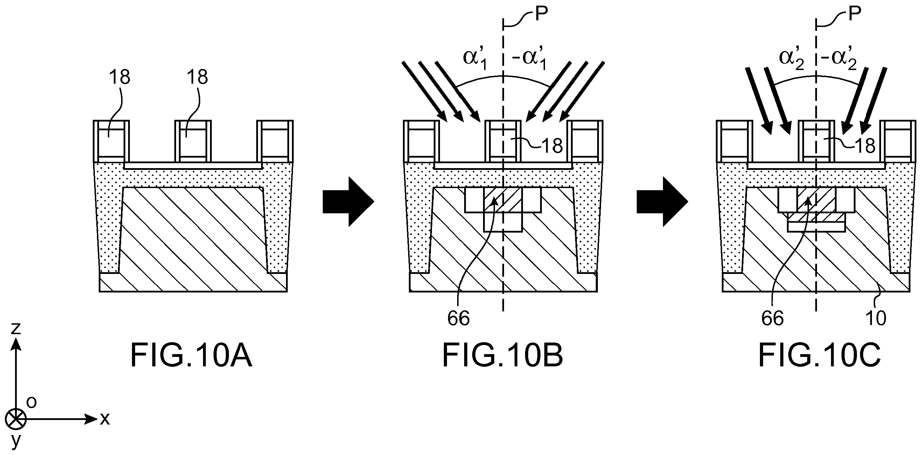

Un autre exemple de procédé de réalisation de la zone photosensible est illustré sur les figures 10A-10C.

On forme tout d'abord une ou plusieurs grilles 18 de transistors (figure 10A).

Puis, on effectue de premières implantations inclinées respectivement selon des angles α'₁ et -α'₁ par rapport à un plan P donné orthogonal au plan principal du substrat, et qui s'étend dans le sens de sa largeur de la grille 18. On peut prévoir par exemple un angle α'₁ de l'ordre de 30°.

On dope ainsi une portion 66 de la couche de support 10 située en face de la grille 18 et on réalise un dopage de type N de cette portion 66 (figure 10B).

Ensuite, on effectue d'autres implantations inclinées respectivement selon des angles α'₂ et -α'₂ plus faibles par rapport au plan P, et prévus de sorte que α'₂ < α'₁. Par exemple α'₂ peut être prévu de l'ordre de 0 à 30°

Ces autres implantations sont typiquement effectuées avec une énergie d'implantation supérieure à celle utilisée pour mettre en œuvre les premières implantations. Elles permettent de renforcer le dopage et d'augmenter la profondeur de la portion 66 dopée N dans la couche de support 10.

Un autre mode de réalisation de la zone photosensible prévoit de former une jonction verticale PN ou NP avant de former une ou plusieurs grilles 18 de transistor.

On peut pour cela partir d'un substrat semi-conducteur sur isolant comprenant un puits 13 dopé dans la couche de support 10, le puits ayant par exemple un dopage de type P.

On effectue ensuite une implantation ionique de manière à réaliser un dopage d'une sous-couche supérieure 68 de la couche 10 de support (figure 11A). La sous-couche supérieure 68 est agencée contre la couche isolante 11 et s'étend parallèlement au plan principal du substrat. Le dopage réalisé est de type opposé à celui du puit 13 dopé. Par dopage « de type opposé » on entend que la sous-couche supérieure 68 est dopée selon un dopage de type N lorsque le puit 13 est dopé P (et inversement que la sous-couche supérieure 68 est dopée selon un dopage de type P lorsque le puit 13 est dopé N).

Ensuite, une étape de formation d'au moins une grille 18 de transistor sur la couche semi-conductrice superficielle 12 du substrat est mise en œuvre (figure 11B).

Une implantation de part et d'autre de la grille 18 est ensuite effectuée de sorte à réaliser un dopage de portions 69 de la couche de support situées contre la couche isolante 11 selon un dopage de type opposé à celui effectué précédemment pour doper la sous-couche supérieure 68.

Ainsi, lorsque la sous-couche supérieure 68 est dopée N, les portions 69 sont dopées P. Ces portions 69 sont dopées N lorsque la sous-couche supérieure 68 est dopée P (figure 11C).

Une portion 70 dopée N située sous la grille 18 et protégée par cette dernière lors de l'implantation conserve le même dopage que celui initialement réalisé dans la couche supérieure 68, par exemple un dopage de type N lorsque les portions 69 sont dopée P.

Des blocs semi-conducteurs pourront ensuite être formés sur la couche superficielle 12 de part et d'autre de la grille 18 de sorte à former des régions de source et de drain en regard des portions 69 dopées P.

En variante de l'étape décrite précédemment en liaison avec la figure 11C, on peut implanter la sous-couche supérieure 68, de manière à réaliser des portions faiblement dopées 79, tout en conservant une portion 70 dopée N sous la grille 18 (figure 12A). Ainsi, on réalise un dopage P prévu de sorte à compenser le dopage N initial, afin de former des portions 79 faiblement dopées.

Puis, on effectue au moins une autre implantation de manière à effectuer un dopage de type P ou augmenter le dopage P de parties 83 des portions 79 faiblement dopées.

Cette autre implantation est mise en œuvre de préférence en utilisant une couche de masquage 81 en particulier agencée contre des flancs de la grille. Cette couche de masquage peut être à base par exemple de nitrure de silicium (déposée préférentiellement par une méthode de dépôt conforme, comme l'ALD (« Atomic Layer Déposition ») et permet de protéger des zones 79a faiblement dopées de la couche de support disposées entre la portion 70 dopée N située en regard de la grille et les parties 83 dopées P disposées de part et d'autre de cette portion 70 dopée N (figure 12B).

## Revendications

1. Dispositif photosensible comprenant un substrat semi-conducteur sur isolant sur lequel repose au moins un transistor (T₁), le substrat étant doté d'une couche semi-conductrice superficielle (12) dans laquelle une zone de canal (14), une zone de source (15) et une zone de drain (16) dudit transistor sont agencées, d'une couche isolante (11) séparant la couche semi-conductrice superficielle d'une couche de support (10) semi-conductrice, la couche de support (10) semi-conductrice comprenant une zone photosensible (20) formée de régions dopées (25, 27) respectivement selon au moins un dopage d'un premier type, N ou P, et au moins un dopage d'un deuxième type, P ou N, de sorte à former au moins une jonction, la zone photosensible (20) étant séparée de la zone de canal (14) du transistor (T₁) par l'intermédiaire de la couche isolante 11 du support, la couche isolante (11) étant configurée de manière à permettre un couplage capacitif entre la zone photosensible (20) et la zone de canal (14) du transistor, la zone photosensible (20) comportant parmi lesdites régions dopées (25, 27):
- une première région dopée (25) selon un dopage d'un premier type, la première région dopée étant agencée contre la couche isolante (11) et étant située en regard de la zone (14) de canal,
- une deuxième région dopée (27) selon un dopage d'un deuxième type, la deuxième région dopée (27) étant disposée autour de la première région dopée (25) et s'étendant contre la couche isolante (11) et en regard de zones de source et de drain du transistor,
le dispositif étant **caractérisé en ce que** ledit couplage capacitif est tel qu'une variation de potentiel consécutive à la réception d'un rayonnement lumineux au niveau de la zone photosensible (20) est apte à entrainer un décalage de tension de seuil (V_{T}) du transistor (T₁).

2. Dispositif photosensible selon la revendication 1, la deuxième région dopée (27) s'étendant en outre sous la première région dopée (25), de sorte qu'en regard de la zone (14) de canal, la première région dopée (25) se situe entre la couche isolante (11) et la deuxième région dopée (27).

3. Dispositif photosensible selon l'une des revendications 1 ou 2, dans lequel la zone de canal (14) du transistor est agencée entièrement en regard de la première région dopée (25).

4. Dispositif photosensible selon l'une des revendications 1 à 3, dans lequel, dans une section transversale de la couche de support (10), la première région dopée (25) est entièrement entourée par ladite deuxième région dopée (27).

5. Dispositif photosensible selon l'une des revendications 1 à 4, dans lequel une région intermédiaire (29) faiblement dopée est disposée entre ladite première région dopée et ladite deuxième région dopée.

6. Dispositif photosensible selon la revendication 5, dans lequel la première région dopée (25), la région intermédiaire (29) et la deuxième région dopée (27) forment une jonction de type PIN ou NIP et sont réparties de manière concentrique autour d'une zone donnée (24) de la couche de support située entièrement en regard de la zone de canal du transistor et contre la couche isolante.

7. Dispositif photosensible selon l'une des revendications 1 à 6, dans lequel le transistor est muni d'une grille (18), la première région dopée étant délimitée latéralement par des bords latéraux (25a) disposés en regard d'espaceurs isolants (19) agencés contre la grille.

8. Dispositif photosensible selon l'une des revendications 1 à 7, la couche isolante (11) étant en SiO₂ et ayant une épaisseur comprise entre 5nm et 50nm, de préférence entre 10nm et 25nm, le décalage de tension de seuil V_{T} étant compris entre 10mV et 250mV.

9. Procédé de réalisation d'un dispositif photosensible selon l'une des revendications 1 à 8, dans lequel la couche de support (10) du substrat est dopée selon le dopage du deuxième type, le procédé comprenant des étapes de :
- réalisation sur le substrat d'une grille sacrificielle (58) et d'une couche d'encapsulation (61) autour de la grille sacrificielle,
- retrait de la grille sacrificielle (58) de sorte à former une ouverture (63) entourée par la couche d'encapsulation (61),
- implantation à travers l'ouverture (63), de sorte à doper selon le premier type de dopage, une portion de la couche de support disposée en regard de l'ouverture (63).

10. Procédé de réalisation d'un dispositif photosensible selon l'une des revendications 1 à 8, dans lequel une grille (18) de transistor est formée sur le substrat semi-conducteur sur isolant, la couche de support (10) du substrat étant dopée selon le dopage du deuxième type, le procédé comprenant les étapes de :
- implantations inclinées, respectivement selon un angle α₁ et un angle -α₂ par rapport à un plan donné (P) orthogonal au plan principal du substrat, de sorte à doper selon un dopage du premier type une première portion (64) de la couche de support en regard de la grille,
- implantation parallèlement au plan donné (P) de sorte à doper selon le dopage du deuxième type des deuxièmes portions (65) de la couche de support de part et d'autre de la première portion (64).

11. Procédé de réalisation d'un dispositif photosensible selon l'une des revendications 1 à 8, dans lequel une grille (18) de transistor est formée sur le substrat semi-conducteur sur isolant, la couche de support (10) du substrat étant dopée selon le dopage du deuxième type, le procédé comprenant :
- des premières implantations inclinées respectivement selon des angles α₁ et -α₁ par rapport à un plan donné (P) orthogonal au plan principal du substrat, de sorte à doper sous la grille une portion de la couche de support selon un dopage d'un premier type,
- des deuxièmes implantations inclinées selon respectivement des angles α₂, -α₂ tels que α₂ < α₁ par rapport au plan donné (P) de sorte à augmenter la profondeur de ladite portion dopée ayant un dopage du premier type.

12. Procédé de réalisation d'un dispositif photosensible selon l'une des revendications 1 à 8, la couche de support (10) du substrat étant dopée selon le dopage du deuxième type, le procédé comprenant les étapes de :
- implantation de sorte à doper une sous-couche supérieure (10a) de la couche de support selon un dopage du premier type, puis
- formation d'une grille (18), puis,
- implantation de part et d'autre de la grille, de sorte à doper selon le dopage du deuxième type des portions (79) de la couche de support situées de part et d'autre d'une portion centrale (70) agencée en regard de la grille.

13. Procédé de réalisation d'un dispositif photosensible selon la revendication 12, dans lequel après implantation des portions (79) on forme une couche masquage (81) contre des flancs de la grille, puis on réalise au moins une nouvelle implantation de part et d'autre de la grille de sorte à augmenter le dopage du deuxième type de certaines parties (83) desdites portions (79).

## Patentansprüche

1. Photosensible Vorrichtung, umfassend ein Halbleitersubstrat auf Isoliermittel, auf dem mindestens ein Transistor (T₁) lagert, wobei das Substrat mit einer oberflächlichen Halbleiterschicht (12), in der ein Kanalbereich (14), ein Source-Bereich (15) und ein Drain-Bereich (16) des Transistors vorgesehen sind, einer Isolierschicht (11), die die oberflächliche Halbleiterschicht von einer Halbleiterträgerschicht (10) trennt, dotiert ist, wobei die Halbleiterträgerschicht (10) einen photosensiblen Bereich (20) umfasst, die aus dotierten Regionen (25, 27) jeweils entsprechend mindestens einer Dotierung eines ersten Typs, N oder P, und mindestens einer Dotierung eines zweiten Typs, P oder N, gebildet sind, um mindestens einen Übergang zu bilden, wobei der photosensible Bereich (20) durch die Isolierschicht (11) des Trägers vom Kanalbereich (14) des Transistors (T₁) getrennt ist,
wobei die Isolierschicht (11) so konfiguriert ist, dass sie eine kapazitive Kopplung zwischen dem photosensiblen Bereich (20) und dem Kanalbereich (14) des Transistors ermöglicht,
wobei der photosensible Bereich (20) unter den dotierten Regionen (25, 27) umfasst:
- eine erste dotierte Region (25) entsprechend einer Dotierung eines ersten Typs, wobei die erste dotierte Region gegen die Isolierschicht (11) vorgesehen ist und sich gegenüber dem Kanalbereich (14) befindet,
- eine zweite dotierte Region (27) entsprechend einer Dotierung eines zweiten Typs, wobei die zweite dotierte Region (27) um die erste dotierte Region (25) herum angeordnet ist und sich gegen die Isolierschicht (11) und gegenüber den Source- und Drain-Bereichen des Transistors erstreckt,
wobei die Vorrichtung **dadurch gekennzeichnet ist, dass** die kapazitive Kopplung so ist, dass eine auf den Empfang von Lichtstrahlen im Bereich des photosensiblen Bereichs (20) folgende Änderung des Potentials geeignet ist, um eine Verschiebung der Schwellenspannung (V_{T}) des Transistors (T₁) zu bewirken.

2. Photosensible Vorrichtung nach Anspruch 1, wobei sich die zweite dotierte Region (27) ferner unter der ersten dotierten Region (25) erstreckt, so dass sich die erste dotierte Region (25) in Bezug auf den Kanalbereich (14) zwischen der Isolierschicht (11) und der zweiten dotierten Region (27) befindet.

3. Photosensible Vorrichtung nach einem der Ansprüche 1 oder 2, wobei der Kanalbereich (14) des Transistors vollständig gegenüber der ersten dotierten Region (25) vorgesehen ist.

4. Photosensible Vorrichtung nach einem der Ansprüche 1 bis 3, wobei, in einem Querschnitt der Trägerschicht (10) die erste dotierte Region (25) vollständig von der zweiten dotierten Region (27) umgeben ist.

5. Photosensible Vorrichtung nach einem der Ansprüche 1 bis 4, wobei eine schwach dotierte Zwischenregion (29) zwischen der ersten dotierten Region und der zweiten dotierten Region angeordnet ist.

6. Photosensible Vorrichtung nach Anspruch 5, wobei die erste dotierte Region (25), die Zwischenregion (29) und die zweite dotierte Region (27) einen Übergang vom PIN- oder NIP-Typ bilden und konzentrisch um einen gegebenen Bereich (24) der Trägerschicht verteilt sind, der sich vollständig gegenüber dem Kanalbereich des Transistors und gegen die Isolierschicht befindet.

7. Photosensible Vorrichtung nach einem der Ansprüche 1 bis 6, wobei der Transistor mit einem Gatter (18) ausgestattet ist, wobei die erste dotierte Region seitlich von Seitenrändern (25a) begrenzt wird, die gegenüber isolierenden Abstandhaltern (19) angeordnet sind, die gegen das Gatter vorgesehen sind.

8. Photosensible Vorrichtung nach einem der Ansprüche 1 bis 7, wobei die Isolierschicht (11) aus SiO₂ besteht und eine Dicke zwischen 5 nm und 50 nm, vorzugsweise zwischen 10 nm und 25 nm aufweist, wobei die Verschiebung der Schwellenspannung V_{T} zwischen 10 mV und 250 mV liegt.

9. Verfahren zum Erzeugen einer photosensiblen Vorrichtung nach einem der Ansprüche 1 bis 8, wobei die Trägerschicht (10) des Substrats entsprechend der Dotierung des zweiten Typs dotiert ist, wobei das Verfahren die Schritte umfasst:
- Erzeugen eines Opfergatters (58) und einer Umhüllungsschicht (61) um das Opfergatter auf dem Substrat,
- Entfernen des Opfergatters (58), so dass eine von der Umhüllungsschicht (61) umgebene Öffnung (63) gebildet wird,
- Implantieren eines gegenüber der Öffnung (63) angeordneten Abschnitts der Trägerschicht durch die Öffnung (63), so dass entsprechend dem ersten Typ der Dotierung dotiert wird.

10. Verfahren zum Erzeugen einer photosensiblen Vorrichtung nach einem der Ansprüche 1 bis 8, wobei ein Gatter (18) des Transistors auf dem Halbleitersubstrat auf Isoliermaterial gebildet wird, wobei die Trägerschicht (10) des Substrats entsprechend der Dotierung des zweiten Typs dotiert wird, wobei das Verfahren die Schritte umfasst:
- geneigte Implantationen, jeweils entsprechend einem Winkel α₁ und einem Winkel α₂, in Bezug auf eine gegebene Ebene (P), die orthogonal zur Hauptebene des Substrats ist, so dass ein erster Abschnitt (64) der Trägerschicht gegenüber dem Gatter entsprechend einer Dotierung vom ersten Typ dotiert wird,
- zur gegebenen Ebene (P) parallele Implantation, so dass zweite Abschnitte (65) der Trägerschicht beidseits des ersten Abschnitts (64) entsprechend der Dotierung vom zweiten Typ dotiert werden.

11. Verfahren zum Erzeugen einer photosensiblen Vorrichtung nach einem der Ansprüche 1 bis 8, wobei ein Gatter (18) des Transistors auf dem Halbleitersubstrat auf Isoliermittel gebildet wird, wobei die Trägerschicht (10) des Substrats entsprechend der Dotierung des zweiten Typs dotiert wird, wobei das Verfahren umfasst:
- erste geneigte Implantationen jeweils entsprechend den Winkeln α₁ und - α₁ in Bezug auf eine gegebene Ebene (P), die orthogonal zur Hauptebene des Substrats ist, um unter dem Gatter einen Abschnitt der Trägerschicht entsprechend einer Dotierung vom ersten Typ zu dotieren,
- zweite geneigte Implantationen jeweils entsprechend den Winkeln α₂ und -α₂, so dass α₂ < α₁ in Bezug auf die gegebene Ebene (P), um die Tiefe des dotierten Abschnitts zu erhöhen, wobei es sich um eine Dotierung vom ersten Typ handelt.

12. Verfahren zum Erzeugen einer photosensiblen Vorrichtung nach einem der Ansprüche 1 bis 8, wobei die Trägerschicht (10) des Substrats entsprechend der Dotierung des zweiten Typs dotiert ist, wobei das Verfahren die Schritte umfasst:
- Implantieren, um eine obere Unterschicht (10a) der Trägerschicht entsprechend einer Dotierung des ersten Typs zu dotieren, anschließend
- Bilden eines Gatters (18), anschließend,
- Implantieren beidseits des Gatters, so dass Abschnitte (79) der Trägerschicht, die sich beidseits eines zentralen Abschnitts (70), der gegenüber dem Gatter vorgesehen ist, befinden, entsprechend der Dotierung des zweiten Typs dotiert werden.

13. Verfahren zum Erzeugen einer photosensiblen Vorrichtung nach Anspruch 12, wobei nach dem Implantieren der Abschnitte (79) eine Maskierungsschicht (81) gegen die Seiten des Gatters gebildet wird, anschließend eine neue Implantation beidseits des Gatters erzeug wird, so dass die Dotierung des zweiten Typs bestimmter Teile (83) der Abschnitte (79) erhöht wird.

## Claims

1. A photosensitive device comprising a semiconductor on an insulator substrate with at least a transistor (T₁) on said substrate, the substrate being provided with a surface semiconducting layer (12) in which a channel zone (14), a source region (15), a drain region (16) of said transistor are arranged,
an insulating layer (11) separating the surface semiconducting layer from a semiconducting support layer (10), the support layer (10) comprising a photosensitive zone (20) formed from regions (25) doped with at least one first doping type, N or P, and at least one second doping type, P or N, so as to form at least one junction,
the insulating layer (11) being configured so as to enable capacitive coupling between the photosensitive zone and the transistor channel zone,
the photosensitive zone comprising the following, among said doped regions (25, 27):
- a first region (25) doped with a first type of doping, the first doped region being arranged in contact with the insulating layer (11) and facing the channel zone,
- a second region (27) doped with a second type of doping, the second doped region being arranged around the first doped region and extending in contact with the insulating layer and facing the source and drain regions of the transistor,
the device being **characterized in that** said capacitive coupling is such that a potential variation as a result of receiving light radiation in the photosensitive zone, is such as to lead to a shift of threshold voltage (V_{T}) of the transistor (T₁).

2. The photosensitive device according to claim 1, the second doped region (27) further extending under the first doped region (25) such that facing the channel zone (14), the first doped region (25) is located between the insulating layer (11) and the second doped region (27).

3. The photosensitive device according to any of the claims 1 or 2, wherein the transistor channel zone (14) is entirely facing the first doped region (25).

4. The photosensitive device according to any of the claims 1 to 3, wherein, in a cross section of the support layer (10), the first doped region (25) being entirely surrounded by said second doped region (27).

5. The photosensitive device according to any of the claims 1 to 4, wherein a slightly doped intermediate region (29) is located between said first doped region and said second doped region.

6. The photosensitive device according to claim 5, wherein the first doped region (25), the intermediate region (29), and the second doped region (27) form a PIN or NIP type junction and are distributed concentrically around a given zone (24) of the support layer entirely located facing the transistor channel zone and in contact with the insulating layer.

7. The photosensitive device according to any of the claims 1 to 6, wherein the transistor is provided with a gate (18), the first doped region being delimited laterally by lateral edges facing insulating spacers (19) arranged in contact with the gate.

8. The photosensitive device according to any of the claims 1 to 7, the insulating layer (11) being made of SiO₂ with a thickness between 5 nm and 50 nm, preferably between 10 nm and 25 nm, the shift of threshold voltage V_{T} being comprised between 10 mV and 250 mV.

9. A method for making a photosensitive device according to any of the claims 1 to 8, wherein the substrate support layer (10) is doped with a second doping type, the method including steps to:
- make a sacrificial gate (58) and an encapsulation layer (61) around the sacrificial gate, on the substrate,
- remove the sacrificial gate (58) so as to form an opening (63) surrounded by the encapsulation layer (61),
- implantation through the opening (63), so as to dope a portion of the support layer facing the opening, with the first type of doping (63).

10. A method for making the photosensitive zone of a photosensitive device according to any of the claims 1 to 8, wherein a transistor gate (18) is formed on the semiconductor on insulator substrate, the support layer (10) of the substrate being doped with the second type of doping, the method including steps to:
- make inclined implantations, at an angle α₁ and at an angle -α₂ respectively from a given plane orthogonal to the principal plane of the substrate, so as to apply a first type of doping to a first portion of the support layer facing the gate,
- make an implantation parallel to the given plane so as apply a second type of doping to second portions of the support layer on each side of the first portion.

11. A method for making a photosensitive device according to one of claims 1 to 8, wherein a transistor gate (18) is formed on the semiconductor on insulator substrate, the support layer (10) of the substrate being doped with the second type of doping, the method including:
- first implantations inclined by angles α₁ and -α₁ respectively from a given plane orthogonal to the principal plane (P) of the substrate, so as to dope a first portion (64) of the substrate layer under the gate with a first type of doping,
- second implantations inclined by angles α₂, -α₂ respectively such that α₂ < α₁ from a given plane so as to increase the depth of said doped portion with a first type of doping.

12. A Method for making a photosensitive device according to any of the claims 1 to 8, the substrate support layer (10) being doped with a second doping type, the method including the following steps:
- implantation so as to dope an upper underlayer (10a) of the support layer with a first type of doping, then
- formation of a gate (18), then,
- implantation on each side of the gate, so as to dope portions (79) of the support layer located on each side of a central portion (70) located facing the gate, with the second type of doping.

13. Method for making a photosensitive zone according to claim 12, wherein after implantation of the portions (79), a masking layer (81) is formed in contact with the flanks of the gate, and then at least a further implant is made on each side of the gate so as to increase the second type of doping of some parts (83) of said portions (79).
